# EUROPÄISCHE PATENTSCHRIFT

(11) **EP 0 493 738 B1**
(45) Veröffentlichungstag und Bekanntmachung des Hinweises auf die Patenterteilung: **09.07.1997**
(21) Anmeldenummer: 91121612.5
(22) Anmeldetag: 17.12.1991
(51) Int. Cl.: G06K 19/077

(54) **Datenträger mit integriertem Schaltkreis**
Record carrier with integrated circuit
Support d'information avec circuit intégré

(30) Priorität: 19.12.1990 DE 4040770
(43) Veröffentlichungstag der Anmeldung: 08.07.1992
(73) Patentinhaber: GAO Gesellschaft für Automation und Organisation mbH, 81307 München (DE)
(72) Erfinder: Haghiri, Yahya, 80797 München (DE); Barak, Renée-Lucia, 82008 Unterhaching (DE)
(74) Vertreter: Klunker . Schmitt-Nilson . Hirsch

(56) Entgegenhaltungen:
- EP-A- 0 201 952
- EP-A- 0 268 830
- DE-A- 3 248 385
- GB-A- 2 112 324

## Beschreibung

Die Erfindung betrifft einen Datenträger mit integriertem Schaltkreis gemäß dem Oberbegriff des Anspruchs 1 sowie ein Verfahren zur Herstellung eines solchen Datenträgers.

Datenträger mit integriertem Schaltkreis werden beispielsweise als Identifikations- Kredit- oder Buchungskarten oder dergleichen eingesetzt. Eine Möglichkeit zur Herstellung solcher Karten besteht darin, ein sogenanntes Modul oder Trägerelement in eine entsprechend angepaßte Aussparung des Kartenkörpers einzukleben. Die Module oder Trägerelemente, die vorzugsweise aus einem Endlosfilm ausgestanzt werden, bestehen im allgemeinen aus einem Substrat, auf dem ein oder mehrere integrierte Schaltkreise mit Leiterbahnen verbunden sind. Die Leiterbahnen führen zu auf dem Substrat befindlichen Kontaktflächen, die die Kommunikation mit entsprechenden Geräten ermöglichen. Vorzugsweise sind der IC-Baustein und die vom IC-Baustein zu den Kontaktflächen führenden Leiterbahnen von einer Gußmasse umgeben. Es sind bereits viele Verfahren bekannt geworden zur Verbindung des Moduls mit dem Kartenkörper.

Aus der EP-A-0 201 952 sind ein Datenträger sowie ein Verfahren zu dessen Herstellung bekannt, bei dem ein Trägerelement über eine Klebeschicht in die Aussparung eines Kartenkörpers eingeklebt ist. Das Trägerelement besteht hierbei aus einem Substrat, auf dessen einer Seite sich Kontaktflächen befinden und auf dessen anderer Seite die Klebeschicht und ein IC-Baustein angeordnet sind. Die Klebeschicht umschließt hierbei den IC-Baustein, der in einem Fenster des Substrates angeordnet ist, leitend mit den Kontaktflächen verbunden ist und einen dünnen Überzug aus einer Gußmasse aufweist.

Aus der EP-A-0 299 530 ist es beispielsweise bekannt, das Trägerelement mit Hilfe einer thermoaktivierbaren Klebeschicht in einer angepaßten Aussparung der Karte mit dem Kartenkörper zu verbinden. Bei der bekannten Lösung hat die Heißklebeschicht eine Doppelfunktion. Sie dient nicht nur dazu, das Trägerelement mit der Karte zu verbinden, sondern auch dazu, einen Begrenzungsrahmen für die Gußmasse zu bilden. Dazu wird auf dem mit dem IC-Baustein, den Leiterbahnen und den Kontaktflächen vorbereiteten Substrat eine Klebeschicht aufgebracht, die im Bereich des IC-Bausteins eine Aussparung aufweist. Anschließend wird der durch die Aussparung gebildete Bereich mit einer Gußmasse gefüllt, wobei die Dosierung der Masse derart eingestellt ist, daß der IC-Baustein vollständig eingeschlossen ist, die Klebeschicht aber, die die Gußmasse begrenzt, vollständig frei bleibt.

Dieses Dokument offenbart die Merkmale der Präambeln der Ansprüche 1 und 5.

Die Verwendung einer thermoaktivierbaren Klebeschicht zur Verbindung eines Trägerelements mit einem Kartenkörper ist auch aus der EP-A 0 334 733 bekannt. Bei dieser bekannten Lösung ist im Kartenkörper eine zweistufige Aussparung vorgesehen. Eine erste Aussparung dient der Aufnahme des Substrats, während eine zweite innerhalb der ersten angeordnete tiefere Aussparung für die Aufnahme des integrierten Schaltkreises vorgesehen ist. Auf dem Schulterbereich der tieferen Aussparung ist das Trägerelement mit dem Kartenkörper verklebt. Ein zur Verklebung eingesetzter, ringförmig gestanzter Heißklebefilm wird vorab in die Aussparung eingesetzt. Nach dem Einsetzen des Trägerlements wird dieses unter Anwendung von Wärme und Druck mit dem Kartenkörper verbunden.

Da der Klebering unabhängig vom Trägerelement gestanzt und vorab in die Aussparung der Karte eingesetzt wird, haben alle Toleranzen in den Abmaßen der Aussparung des Kleberings und des Trägerelements Einfluß auf die Lage von Trägerelement und Klebering in der Aussparung, das heißt, daß in der Regel nicht die gesamte zur Verfügung stehende Klebefläche genutzt wird, was zwangsläufig eine geringere Festigkeit in der Verbindung zwischen Trägerelement und Karte zur Folge hat.

Bei der Verklebung des Trägerelements mit dem Kartenkörper unter Einwirkung von Wärme und Druck verbindet sich auch ein auf dem Boden des Sacklochs der Aussparung befindlicher Epoxydharztropfen mit dem IC-Baustein. Mit dieser Maßnahme soll erreicht werden, daß das ausgehärtete Harz die mechanische Resistenz des Bodenbereichs der Aussparung verbessert. Die Maßnahme scheint aber den Nachteil zu haben, daß der IC-Baustein bei einer entsprechenden Biegebeanspruchung der Karte im Bodenbereich des Sacklochs durch die Versteifung des ausgehärteten Epoxydharzes einer starken mechanischen punktuellen Belastung ausgesetzt ist. Des weiteren wird der durch die Heißklebeschicht hergestellte Verbund zwischen Trägerelement und Kartenkörper bei Biegebelastungen aufgrund der Versteifung im Bodenbereich des Sacklochs stärker beansprucht. Dies kann zur Ablösung der Klebeschicht am Trägerelement oder an der Karte führen.

Der Erfindung liegt die Aufgabe zugrunde, bei einer Verklebung eines Trägerelementes in Datenträgern mit Hilfe einer thermoaktivierbaren Klebeschicht eine sehr gute und dauerhafte Verbindung zu erzielen bei gleichzeitig gutem Schutz des IC-Bausteins gegen mechanische Belastungen.

Die Aufgabe wird durch die Merkmale der Ansprüche 1,5,7 und 11 gelöst.

Der gemeinsame erfinderische Grundgedanke der Ansprüche ist darin zu sehen, daß die Klebeschicht so gestanzt ist, daß die Fläche, auf der die Klebeschicht das Trägerelement mit dem Kartenkörper verklebt, vergrößert wird und gleichzeitig das Trägerelement gegenüber dem Kartenkörper entkoppelt wird.

Bei der Erfindung wird von einem Endlosfilm ausgegangen, auf dem integrierte Schaltkreise montiert und mit einer Gußmasse versehen sind. Dieser Endlosfilm wird mit einem thermoaktivierbaren Klebefilm zusammengeführt. Der Klebefilm hat Öffnungen, die derart bemessen und zum Trägerfilm positioniert werden, daß die Klebeschicht nicht nur den Trägerfilm, sondern auch die Gußmasse in den Randbereichen zumindest teilweise überdeckt. Die Trägerelemente werden gemeinsam mit der Klebeschicht aus dem Endlosmaterial gestanzt. Das so mit einer Klebeschicht versehene Trägerelement wird unter Anwendung von Wärme und Druck in einer zweistufigen Aussparung eines Datenträgers mit dem Kartenmaterial verbunden.

Mit der erfindungsgemäßen Lösung wird die zur Verfügung stehende Klebefläche in der Aussparung unabhängig von Toleranzen in jedem Fall vollständig ausgenutzt. Man erzielt damit eine gleichmäßige, großflächige und dauerhafte Verbindung zwischen Trägerelement und Kartenkörper. Aufgrund der Aussparung in der Klebeschicht verbleibt ein Hohlraum zwischen der Gußmasse des Trägerelements einerseits und dem Bodenbereich des Sacklochs der Aussparung andererseits. Durch diesen Hohlraum hat der IC-Baustein mit der Vergußmasse auch bei entsprechenden Biegebeanspruchungen des Kartenkörpers eine gewisse Bewegungsfreiheit, wodurch der IC-Baustein bei Biegebeanspruchungen der Karte entlastet wird. Druckbelastungen im Bereich der Trägerelemente werden nicht direkt auf den IC-Baustein übertragen. Da zwischen dem Gußkörper und dem im allgemeinen sehr dünnen Bodenbereich der Aussparung keine Verbindung hergestellt wird, ist die thermische Belastung des Kartenmaterials im Bodenbereich während des Einbaus des Trägerelements sehr gering. Es hat sich gezeigt, daß aufgrund dessen die dem Trägerelement gegenüberliegende rückseitige Kartenoberfläche im Bereich des Bodens keinerlei Verzüge oder Deformationen aufweist. Dies ist besonders dann von Bedeutung, wenn die Kartenrückseite beispielsweise bedruckt werden soll, wozu eine besonders plane Oberfläche wünschenswert ist.

Bei der erfindungsgemäßen Vorgehensweise wird das Trägerelement immer auch im Randbereich des Gußkörpers über die Klebeschicht mit dem Kartenkörper verbunden, wodurch die Haftung zwischen Trägerelement und Kartenkörper insgesamt noch verbessert werden kann.

Weitere Vorteile und Weiterbildungen der Erfindung ergeben sich aus den Unteransprüchen sowie den Ausführungsbeispielen, die nachfolgend anhand der Figuren beschrieben werden. Darin zeigen:
- Fig. 1: eine Ausweiskarte mit eingebautem Trägerelement in der Draufsicht,
- Fig. 2: einen Trägerfilm mit darauf angeordneten IC-Bausteinen und mit einem Heißklebeband im Schnitt,
- Fig. 3: eine Ausweiskarte mit eingebautem Trägerelement gemäß Fig. 1 im Schnitt,
- Fig. 4a - 4c: ein Verfahren zur Herstellung einer Ausweiskarte gemäß Fig. 3 und
- Fig. 5: eine Heißklebeschicht.

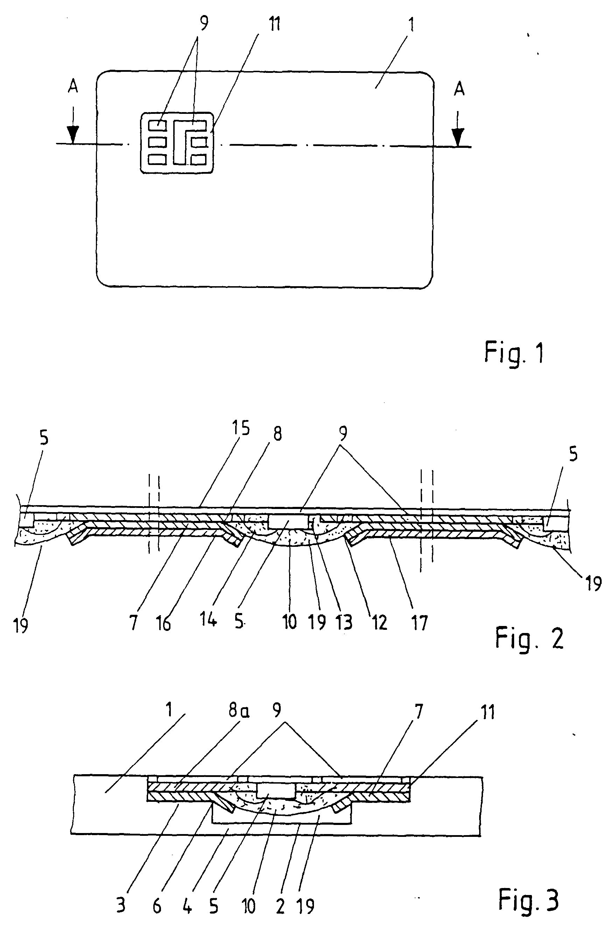

Fig. 1 zeigt in einer beispielhaften Ausführungsform eines Datenträgers eine Ausweiskarte 1 mit eingebautem Trägerelement 11, auf dessen Oberfläche die Kontaktflächen 9 liegen. Die Ausweiskarte 1 kann aus einer einzigen Schicht oder auch aus mehreren Schichten aufgebaut sein.

Fig. 2 zeigt in einer Schnittdarstellung einen Ausschnitt eines mit dem Trägerfilm 8 verbundenen Heißklebebandes 17. Der Trägerfilm 8 dient zur Aufnahme der IC-Bausteine 5 in regelmäßiger Anordnung. In dem gezeigten Ausführungsbeispiel ist der IC-Baustein 5 in einer Aussparung 13 des Trägerfilms 8 direkt mit einer leitenden Schicht 15, beispielsweise mit Hilfe eines Klebstoffes, verbunden. Aus der leitenden Schicht 15 kann das gewünschte Kontaktdesign mit den Kontaktflächen 9 ausgeätzt werden. Die Aussparungen 12 im Trägerfilm 8 ermöglichen den Zugang zu den Kontaktflächen 9. So kann auf einfache Weise eine elektrische Verbindung zwischen den Anschlußpunkten des IC-Bausteins 5 und den entsprechenden Kontaktflächen 9 hergestellt werden. In dem gezeigten Ausführungsbeispiel wurde die sogenannte Drahtbondtechnik eingesetzt, bei der feine Golddrähte oder Aluminiumdrähte die elektrische Verbindung (Leiterbahnen 14) herstellen. Zum Schutz vor mechanischen Belastungen wird eine Gußmasse 10 auf der den Kontaktflächen 9 gegenüberliegenden Seite des Trägerfilms 8 aufgebracht, die eine solche Größe hat, daß der IC-Baustein 5, die Leiterbahnen 14 und die in den Aussparungen 12 liegenden Verbindungspunkte zwischen den Leiterbahnen 14 und den Kontaktflächen 9 von der Gußmasse 10 eingeschlossen sind. Als Gußmasse 10 kann ein aushärtendes Harz verwendet werden. Das auf der zweiten Seite des Trägerfilms 8 angeordnete Heißklebeband 17 besteht aus einem Trägerband 16 mit einer darauf befindlichen Heißklebschicht 7 und ist mittels dieser mit dem Trägerfilm 8 fest verbunden. Das Heißklebeband 17 ist in regelmäßigen Abständen mit Öffnungen 19 versehen. Die Größe der Öffnungen 19 im Heißklebeband 17 ist derart bemessen, daß die auf dem Trägerfilm 8 befindliche Gußmasse 10 im Randbereich zumindest teilweise vom Heißklebeband 17 überdeckt wird. Das Trägerband 16 wird vor dem Einbau des Trägerelementes 11 in eine Ausweiskarte abgezogen.

Fig. 3 zeigt die fertiggestellte Ausweiskarte 1 im Schnitt gemäß der in Fig. 1 gezeigten Linie A-A. Die für den Einbau des Trägerelements 11 entsprechend geformte zweistufige Aussparung 3 in der Karte 1 besitzt in ihrem Mittenbereich ein Sackloch 2 zur Aufnahme des mit einem Gießharz vergossenen IC-Bausteins 10. Die zweistufige Aussparung 3 kann mit dem dazugehörigen tieferen Sackloch 2 beispielsweise in einem aus einer Kunststoffplatte bestehenden Kartenkörper gefräst werden. Besteht die Karte 1 aus mehreren Schichten, beispielsweise aus einer Kernschicht und einer oberen und unteren Deckschicht, so wird die obere Deckschicht und die Kernschicht mit einer entsprechenden Öffnung versehen, um das Trägerelement paßgenau einbetten zu können. Das in den Fig. 1 und 3 gezeigte Trägerelement 11 wurde unter der Einwirkung von Wärme und Druck mit Hilfe der Heißklebeschicht 7 mit dem Körper der Karte 1 dauerhaft verbunden, wobei die Heißklebeschicht 7 das Substrat 8a, welches aus dem in Fig. 2 dargestellten Trägerfilm 8 ausgestanzt wurde, vollständig und die Gußmasse 10 zumindest teilweise bedeckt. Dadurch, daß die Heißklebeschicht 7 gemeinsam mit dem Trägerfilm 8 gestanzt wird und die Klebeschicht 7 die Gußmasse 10 in den Randbereichen überlappt, wird unabhängig von Toleranzen bei der Herstellung der Aussparung 3 immer die gesamte zur Verfügung stehende Klebefläche zur Befestigung des Trägerelements 11 mit dem Kartenkörper 1 genutzt. Dies führt zu einer entsprechend festen und dauerhaften Verbindung zwischen Trägerelement 11 und der Karte 1. Die Überlappung der Gußmasse 10 durch die Klebschicht 7 führt auch dazu, daß die Stufenkante 6 in der Aussparung 3 von der Heißklebeschicht 7 abgedeckt wird. Durchprägungen dieser Kante 6 auf die Kartenrückseite 4, die sich bei der notwendigen Einwirkung von Wärme und Druck zum Einbau des Trägerelementes 11 in die Karte 1 einstellen können, werden auf diese Weise minimiert bzw. vermieden. Diese Puffer- bzw. Schutzfunktion erfüllt die Klebeschicht 7 bezüglich der Kanten 6 auch bei entsprechenden mechanischen Belastungen im täglichen Gebrauch der Karte 1. Schließlich führt die Überlappung dazu, daß auch die Gußmasse 10 über die Klebeschicht 7 mit dem Kartenkörper 1 verbunden wird, was die Verbindung des Trägerelements 11 mit dem Kartenkörper 1 insgesamt noch verbessert.

Die Öffnung 19 in der Klebeschicht 7 im Bereich des Sacklochs 2 führt dazu, daß des Trägerelement 11 im Bereich der Gußmasse 10 nicht mit dem Boden des Sacklochs 2 verbunden wird und daß während des Einbaus des Trägerelements 11 weniger Wärme an die vergleichsweise dünne Rückwandung 4 der Karte übertragen wird. Dadurch können Verzüge bzw. Deformationen der dünnen Rückwand 4 der Karte 1 vermieden werden. Die Öffnung 19 in der Klebeschicht 7 führt weiterhin dazu, daß im Bereich des Sacklochs 2 unterhalb der Gußmasse 10 ein Hohlraum verbleibt, der eine gewisse Bewegungsfreiheit des Trägerelements 11 ermöglicht. Dies wirkt sich bei Biegebeanspruchungen der Karte 1 entlastend auf die den IC-Baustein 5 aus. Der Hohlraum ermöglicht es außerdem, daß ein gewisser Toleranzspielraum hinsichtlich der Dicke der Gußmasse 10 zugelassen werden kann.

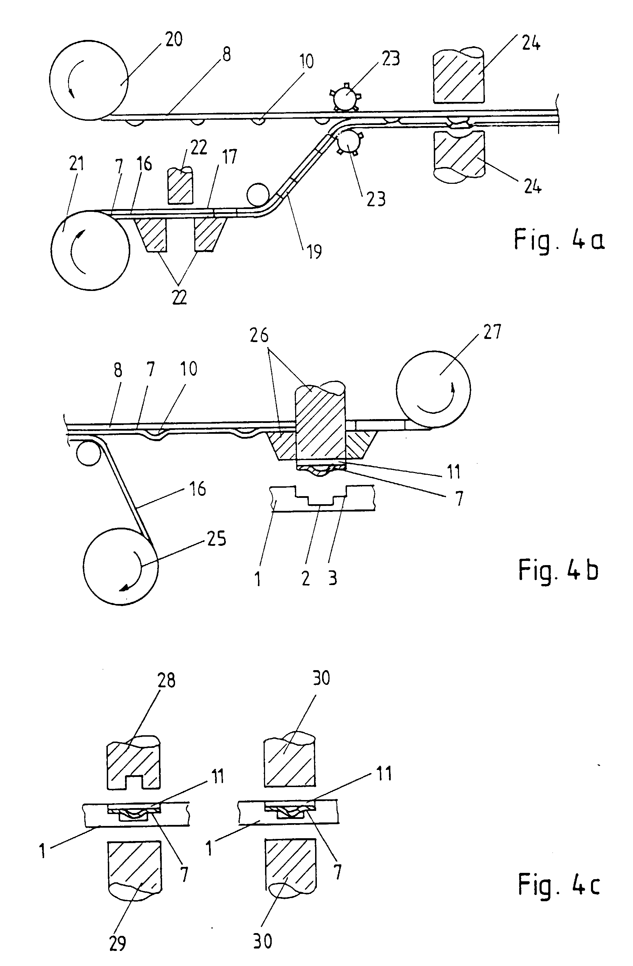

Anhand der Fig. 4a bis 4c soll nachfolgend ein Verfahren zur Herstellung des erfindungsgemäßen Datenträgers erläutert werden. Die Fig. 4a zeigt den von einer Rolle 20 abgespulten in Endlosform vorliegenden Trägerfilm 8 mit den darauf montierten und im Anschluß mit einem Gießharz 10 vergossenen IC-Bausteinen. Das Heißklebeband 17, bestehend aus dem Trägerband 16 mit der darauf befindlichen Heißklebeschicht 7, liegt ebenfalls in Endlosform vor und wird von der Rolle 21 ebenfalls abgespult. Aus dem Heißklebeband 17 werden mit einem entsprechenden Stanzwerkzeug 22 in regelmäßigen Abständen die Öffnungen 19 ausgestanzt. Das mit den Öffnungen 19 versehene Heißklebeband 17 wird mit dem Trägerfilm 8 zur weiteren Verarbeitung mittels entsprechenden Führungsrollen 23 paßgenau zusammengeführt, wobei die Stanzöffnungen 19 im Heißklebeband 17 zum getakteten Transport genutzt werden können. Die auf dem Trägerfilm 8 entsprechend der Anordnung der IC-Bausteine vorgesehenen Gußmassen 10 werden zumindest teilweise vom Heißklebeband 17 überdeckt. Nach erfolgter Positionierung kann das Heißklebeband 17 unter der Einwirkung von Wärme und Druck mit Hilfe eines Heißsiegelstempels 24 mit dem Trägerfilm 8 verbunden werden. Zu diesem Zweck können auch mehrere Heißsiegelstempel 24 eingesetzt werden, die dann im Parallelbetrieb mit gleichem Takt arbeiten. Das Laminat, bestehend aus dem Trägerfilm 8 und dem Heißklebeband 17, kann zur Lagerhaltung auf einer nicht dargestellten Rolle aufgewickelt werden. Das Laminat kann aber auch direkt den folgenden Verfahrensschritten zugeführt werden.

Die Fig. 4b zeigt ein Stanzwerkzeug 26, mit dem aus dem Laminat die Trägerelemente 11 gemeinsam mit der Heißklebeschicht 7 aus dem Trägerfilm 8 bzw. aus dem Heißklebeband 17 ausgestantzt werden. Das Trägerband 16 wird vor dem Stanzvorgang abgezogen und auf der Rolle 25 aufgewickelt. Das mit der Heißklebeschicht 7 unterlegte Trägerelement 11 kann von dem Stanzwerkzeug 26 auch gehalten und in den mit einer zweistufigen Aussparung 3 versehenen Kartenkörper 1 eingebaut werden. Das nach dem Ausstanzen der Trägerelemente 11 und Heißklebeschichten 7 verbleibende Gitter wird auf der Rolle 27 aufgewickelt.

Die Fig. 4c zeigt den Stempel 28, mit dem das Trägerelement 11 mittels der Heißklebeschicht 7 mit der Karte 1 verbunden wird. Die Rückseite der Karte 1 kann hierbei mit Hilfe eines entsprechenden Külstempels 29 gekühlt werden. Dies hat den Vorteil, daß die Verklebung mit relativ hohen Temperaturen erfolgen kann, die ein schnelles und gutes Verkleben garantieren, ohne daß die Kartenrückseite 4 vor allem im dünnen bodenbereich des Sacklochs einer hohen Temperatur ausgesetzt ist.

Zur weiteren Verbesserung der Planlage des Datenträgers 1 im Bereich des Trägerelements 11 und der Oberflächenbeschaffenheit im dünnen Bodenbereich des Sacklochs 2 hat es sich als vorteilhaft erwiesen, wenn der Datenträger 1 in einer letzten Station unter Druck mit Hilfe geeigneter Kühlstempel 30 abgekühlt wird.

Bei den bisher beschriebenen Ausführungsformen ist die öffnung im Heißklebeband kreisrund gestanzt. Je nach Wahl des Stanzwerkzeugs sind andere Konturen möglich.

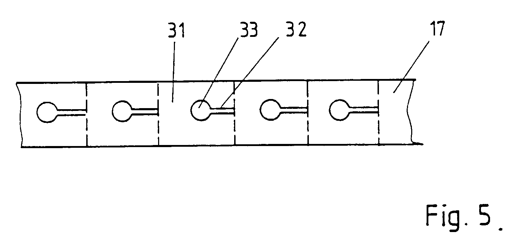

Die Fig. 5 zeigt ein Heißklebeband 17, aus dem entlang der strichlierten Linien Elemente 31, wie oben beschrieben, ausgestanzt werden. In jedem Element 31 ist eine kreisförmige Öffnung 33 gestanzt mit einem Kanal 32, der von der Öffnung 33 zum strichliert angedeuteten Stanzrand des Elements 31 führt. Durch den Kanal 32 wird eine hermetische Abdichtung des im Sackloch 2 der Karte 1 verbleibenden Hohlraums vermieden. Ein in diesem Hohlraum unter der Einwirkung von Wärme möglicherweise entstehender Überdruck, der eine Belastung für Karte und Modul sein kann, wird über den Kanal ausgeglichen. Der Kanal 32 kann abhängig von der Dicke des Klebefilms derart dimensioniert werden, daß auch bei der fertiggestellten Karte eine Öffnung bestehen bleibt, die den Hohlraum mit der Umgebung der Karte verbindet

Bei Karten mit dünnen Wandstärken im Bodenbereich, die aufgrund ihres Einsatzgebiets vergleichsweise hohen und auch niedrigen Temperaturen ausgesetzt sein können, wird eine Deformation des Kartenmaterials im Bereich des Hohlraums vermieden, wenn sich ein Druckausgleich über den Kanal 32 einstellen kann. Mit einer leicht modifizierten Stanzung gemäß Fig. 5 kann diese, die dauerhafte Stabilität der Karte fördernde Funktion erreicht werden.

## Patentansprüche

1. Datenträger, bestehend aus einem Kartenkörper (1) mit einer Aussparung, in der ein Trägerelement angeordnet ist, welches aus einem Substrat (8) besteht mit einer ersten Seite mit mehreren Kontaktflächen (9) und mit einer der ersten gegenüberliegenden zweiten Seite mit einem IC-Baustein (5), dessen Anschlußpunkte über elektrische Leiter (14) mit den Kontaktflächen verbunden sind, wobei wenigstens der IC-Baustein von einer Gußmasse (10) umgeben ist und die zweite Seite des Trägerelements mit Hilfe einer thermoaktivierbaren Klebeschicht (7) mit dem Kartenkörper verbunden ist, wobei die thermoaktivierbare Klebeschicht mit einer Öffnung (19) versehen ist, dadurch gekennzeichnet, daß die Öffnung derart bemessen und zum Trägerelement positioniert ist, daß sie die Gußmasse zumindest in den Randbereichen, teilweise überdeckt.

2. Datenträger nach Anspruch 1, dadurch **gekennzeichnet**, daß die Gußmasse die Form eines Tropfens hat und die öffnung in der Klebeschicht zentrisch zur Geometrie des Tropfens positioniert ist.

3. Datenträger nach Anspruch 1, dadurch **gekennzeichnet**, daß die Dicke des Trägerelements im Bereich der Gußmasse geringer ist als die Tiefe der Aussparung, so daß zwischen der Gußmasse und dem Boden der Aussparung ein Hohlraum verbleibt.

4. Datenträger nach Anspruch 3, dadurch **gekennzeichnet**, daß die thermoaktivierbare Klebeschicht neben der Öffnung (33) im Bereich der Gußmasse wenigstens einen Kanal (32) aufweist, der von der Öffnung und damit vom Hohlraum zum Rand des Trägerelements führt.

5. Trägerelement für einen IC-Baustein, bestehend aus einem Substrat (8) mit einer ersten Seite mit mehreren Kontaktflächen (9) und mit einer der ersten gegenüberliegenden zweiten Seite mit einem IC-Baustein (5), dessen Anschlußpunkte über elektrische Leiter (14) mit den Kontaktflächen verbunden sind, wobei wenigstens der IC-Baustein von einer Gußmasse (10) umgeben ist und die zweite Seite des Trägerelements eine thermoaktivierbare Klebeschicht (7) aufweist, wobei die Klebeschicht mit einer Öffnung (19) versehen ist, dadurch gekennzeichnet, daß die Öffnung derart bemessen und zur Gußmasse positioniert ist, daß sie diese zumindest in den Randbereichen, teilweise überdeckt.

6. Trägerelement nach Anspruch 5, dadurch **gekennzeichnet**, daß die Klebeschicht neben der Öffnung (33) im Bereich der Gußmasse wenigstens einen Kanal (32) aufweist, der von der öffnung zum Rand des Substrats verläuft.

7. Verfahren zur Herstellung eines Datenträgers bestehend aus einem Kartenkörper und mit integriertem Schaltkreis (5), der sich auf einem Trägerelement befindet, das mittels einer thermoaktivierbaren Klebeschicht (7) in einer Aussparung des Kartenkörpers mit dem Kartenkörper (1) verbunden wird, mit folgenden Verfarhrensschritten:
- Zuführen eines Heißklebebandes (17) in Form von Endlosmaterial, bestehend aus einer Klebeschicht (7) und mindestens einer Trägerschicht (16),
- Zuführen eines Trägerfilms mit integrierten Schaltkreisen (5) in Form von Endlosmaterial, wobei zumindest die Schaltkreise jeweils von einer Gußmasse (10) umgeben sind,
- Stanzen von Öffnungen (19) im Heißklebeband,
- positioniertes Zusammenführen von Heißklebeband und Trägerfilm derart, daß die Klebeschicht die Gußmasse zumindest in den Randbereichen, teilweise überdeckt,
- Verbinden der Klebeschicht mit dem Trägerfilm,
- Entfernen der Trägerschicht vom Heißklebeband,
- Ausstanzen von Trägerelementen aus dem Verbund Trägerfilm/Klebeschicht und Einsetzen in eine Aussparung des Kartenkörpers (1),
- Verbinden des Trägerelements in der Aussparung mit dem Kartenkörper unter Anwendung von Wärme und Druck.

8. Verfahren nach Anspruch 7, dadurch **gekennzeichnet**, daß zum positionierten Zusammenführen von Heißklebeband und Trägerfilm die Stanzöffnungen im Klebeband genutzt werden.

9. Verfahren nach Anspruch 7, dadurch **gekennzeichnet,** daß während der Wärmeaktivierung der Heißklebeschicht die dem Trägerelement gegenüberliegende Rückseite des Kartenkörpers gekühlt wird.

10. Verfahren nach Anspruch 7, dadurch **gekennzeichnet**, daß der Datenträger nach dem Einbau des Trägerelements in eine weitere Station geführt wird, in der der Kartenkörper zumindest im Bereich des Trägerelements unter Druck abgekühlt wird.

11. Verfahren zur Herstellung eines Trägerfilms mit integrierten Schaltkreisen (5) in Verbindung mit einer thermoaktivierbaren Klebeschicht (7), mit folgende Verfahrensschritte:
- Zuführen eines Heißklebebandes (17) in Form von Endlosmaterial bestehend aus einer Klebeschicht (7) und mindestens einer Trägerschicht (16),
- Zuführen eines Trägerfilms mit integrierten Schaltkreisen (5) in Form von Endlosmaterial, wobei zumindest die Schaltkreise von einer Gußmasse (10) umgeben sind,
- Stanzen von Öffnungen im Heißklebeband,
- positioniertes Zusammenführen von Heißklebeband und Trägerfilm derart, daß die Klebeschicht die Gußmasse zumindest in den Randbereichen, teilweise überdeckt.

## Claims

1. A data carrier comprising a card body (1) with a recess in which a carrier element is disposed which comprises a substrate (8) having a first side with a plurality of contact surfaces (9) and a second side opposite the first with an IC module (5) whose terminals are connected with the contact surfaces via electric conductors (14), whereby at least the IC module is surrounded by a casting compound (10), and the second side of the carrier element is connected with the card body with the aid of a thermally activated adhesive layer (7), whereby the thermally activated adhesive layer is provided with an opening (19), characterized in that the opening is dimensioned and positioned relative to the carrier element in such a way that it partly covers the casting compound at least in the edge areas.

2. The data carrier of claim 1, characterized in that the casting compound has the form of a drop, and the opening in the adhesive layer is positioned centrally with respect to the geometry of the drop.

3. The data carrier of claim 1, characterized in that the thickness of the carrier element in the area of the casting compound is smaller than the depth of the recess so that a cavity remains between the casting compound and the bottom of the recess.

4. The data carrier of claim 3, characterized in that the thermally activated adhesive layer has, alongside the opening (33) in the area of the casting compound, at least one channel (32) leading from the opening, and thus from the cavity, to the edge of the carrier element.

5. A carrier element for an IC module comprising a substrate (8) with a first side with a plurality of contact surfaces (9) and a second side opposite the first with an IC module (5) whose terminals are connected with the contact surfaces via electric conductors (14), whereby at least the IC module is surrounded by a casting compound (10), and the second side of the carrier element has a thermally activated adhesive layer (7), whereby the adhesive layer is provided with an opening (19) characterized in that the opening is dimensioned and positioned relative to the casting compound in such a way that it partly covers the latter, at least in the edge areas.

6. The carrier element of claim 5, characterized in that the adhesive layer has, alongside the opening (33) in the area of the casting compound, at least one channel (32) extending from the opening to the edge of the substrate.

7. A method for producing a data carrier comprising a card body and having an integrated circuit (5) which is located on a carrier element connected with the card body (1) in a recess in the card body by means of a thermally activated adhesive layer (7), comprising the following steps:
supplying a heat-sealing band (17) in the form of endless material comprising an adhesive layer (7) and at least one carrier layer (16),
supplying a carrier film with integrated circuits (5) in the form of endless material, whereby at least the circuits are each surrounded by a casting compound (10),
stamping openings (19) in the heat-sealing band,
bringing together the heat-sealing band and carrier film with proper positioning in such a way that the adhesive layer partly covers the casting compound at least in the edge areas,
connecting the adhesive layer with the carrier film,
removing the carrier layer from the heat-sealing band,
stamping carrier elements out of the compound consisting of the carrier film/adhesive layer and inserting them into a recess in the card body (1),
connecting the carrier element in the recess with the card body under the action of heat and pressure.

8. The method of claim 7, characterized in that the stamped openings in the adhesive band are utilized for bringing together the heat-sealing band and carrier film with proper positioning.

9. The method of claim 7, characterized in that the back of the card body opposite the carrier element is cooled during the thermal activation of the heat-sealing layer.

10. The method of claim 7, characterized in that the data carrier, after incorporation of the carrier element, is guided into a further unit in which the card body is cooled under pressure at least in the area of the carrier element.

11. A method for producing a carrier film with integrated circuits (5) in connection with a thermally activated adhesive layer (7), comprising the following steps:
supplying a heat-sealing band (17) in the form of endless material comprising an adhesive layer (7) and at least one carrier layer (16),
supplying a carrier film with integrated circuits (5) in the form of endless material, whereby at least the circuits are surrounded by a casting compound (10),
stamping openings in the heat-sealing band, bringing together the heat-sealing band and carrier film with proper positioning in such a way that the adhesive layer partly covers the casting compound at least in the edge areas.

## Revendications

1. Support de données composé d'un corps de carte (1) comprenant un évidement dans lequel est disposé un élément de support qui se compose d'un substrat (8) pourvu d'une première face présentant plusieurs surfaces de contact (9) et d'une deuxième face opposée à la première et comportant un composant de circuit intégré (5) dont les points de jonction sont reliés par l'intermédiaire de conducteurs électriques (14) aux surfaces de contact, au moins le composant de circuit intégré étant entouré d'une masse de remplissage (10) et la deuxième face de l'élément de support étant relié au corps de carte à l'aide d'une couche de colle (7) thermoactivable, la couche de colle thermoactivable étant pourvue d'une ouverture (19), caractérisé en ce que l'ouverture est dimensionnée et est positionnée sur l'élément de support de telle façon qu'elle recouvre partiellement la masse de remplissage au moins dans les zones de bord.

2. Support de données selon la revendication 1, caractérisé en ce que la masse de remplissage a la forme d'une goutte et en ce que l'ouverture de la couche de colle est positionnée centrée géométriquement sur la goutte.

3. Support de données selon la revendication 1, caractérisé en ce que l'épaisseur de l'élément de support dans la zone de la masse de remplissage est inférieure à la profondeur de l'évidement de façon qu'un espace vide demeure entre la masse de remplissage et le fond de l'évidement.

4. Support de données selon la revendication 3, caractérisé en ce que la couche de colle thermoactivable présente à côté de l'ouverture (33) dans la zone de la masse de remplissage au moins un canal (32) qui mène de l'ouverture et ainsi de l'espace vide au bord de l'élément de support.

5. Elément de support pour un composant de circuit intégré, composé d'un substrat (8) pourvu d'une première face présentant plusieurs surfaces de contact (9) et d'une deuxième face opposée à la première et comportant un composant de circuit intégré (5) dont les points de jonction sont reliés par l'intermédiaire de conducteurs électriques (14) aux surfaces de contact, au moins le composant de circuit intégré étant entouré d'une masse de remplissage (10) et la deuxième face de l'élément de support présentant une couche de colle (7) thermoactivable, la couche de colle thermoactivable étant pourvue d'une ouverture (19), caractérisé en ce que l'ouverture est dimensionnée et est positionnée par rapport à la masse de remplissage de telle façon qu'elle recouvre partiellement celle-ci au moins dans les zones de bord.

6. Elément de support selon la revendication 5, caractérisé en ce que la couche de colle présente à côté de l'ouverture (33) dans la zone de la masse de remplissage au moins un canal (32) qui s'étend de l'ouverture jusqu'au bord du substrat.

7. Procédé de fabrication d'un support de données composé d'un corps de carte et d'un circuit intégré (5) qui se trouve sur un élément de support qui est relié dans un évidement du corps de carte au moyen d'une couche de colle (7) thermoactivable au corps de carte (1), comprenant les étapes de procédé suivantes consistant à :
- amener une bande thermocollante (17) sous la forme d'une bande sans fin composée d'une couche de colle (7) et d'au moins une couche de support (16),
- amener un film de support pourvu de circuits intégrés (5) sous la forme d'une bande sans fin, au moins les circuits intégrés étant chacun entouré d'un matériau de remplissage (10),
- percer des ouvertures (19) dans la bande thermocollante,
- réunir en les positionnant mutuellement la bande thermocollante et le film de support de telle façon que la couche de colle recouvre partiellement, au moins dans les ; zones de bord, la masse de remplissage,
- relier la couche de colle au film de support,
- ôter la couche de support de la bande thermocollante,
- découper à la matrice des éléments de support de l'ensemble film de support/couche de colle et les mettre en place dans un évidement du corps de carte (1),
- relier l'élément de support situé dans l'évidement au corps de carte en utilisant la chaleur et la pression.

8. Procédé selon la revendication 7, caractérisé en ce que pour réunir en les positionnant mutuellement la bande thermocollante et le film de support on utilise les ouvertures de perçage de la bande de colle.

9. Procédé selon la revendication 7, caractérisé en ce que pendant l'activation par la chaleur de la couche thermocollante la face arrière du corps de carte opposée à l'élément de support est refroidie.

10. Procédé selon la revendication 7, caractérisé en ce que le support de données est conduit, après l'incorporation de l'élément de support, dans un autre poste dans lequel le corps de carte est refroidi sous pression au moins dans la zone de l'élément de support.

11. Procédé de fabrication d'un de film support pourvu de circuits intégrés (5) relié à une couche de colle thermoactivable (7), comprenant les étapes suivantes consistant à :
- amener une bande thermocollante (17) sous la forme d'une bande sans fin composée d'une couche de colle (7) et d'au moins une couche de support (16),
- amener un film de support pourvu de circuits intégrés (5) sous la forme d'une bande sans fin, au moins les circuits intégrés étant chacun entouré d'un matériau de remplissage (10),
- percer des ouvertures dans la bande thermocollante,
- réunir en les positionnant mutuellement la bande thermocollante et le film de support de telle façon que la couche de colle recouvre partiellement, au moins dans les zones de bord, la masse de remplissage.
